# FASCICULE DE BREVET EUROPEEN

(11) **EP 0 296 992 B1**
(45) Date de publication et mention de la délivrance du brevet: **13.08.1997**
(21) Numéro de dépôt: 88420198.9
(22) Date de dépôt: 15.06.1988
(51) Int. Cl.: H03F 3/45, G11B 15/14

(54) **Circuit de commutation de têtes de lecture pour magnétoscopes**
Schaltkreis zum Schalten der Leseköpfe eines Videorecorders
Circuit for switching of reading heads of videorecorders

(30) Priorité: 19.06.1987 FR 8708656
(43) Date de publication de la demande: 28.12.1988
(73) Titulaire: SGS-THOMSON MICROELECTRONICS S.A., 94250 Gentilly (FR)
(72) Inventeur: Meunier, Thierry, D-7730 Obereschach (DE)
(74) Mandataire: de Beaumont, Michel

(56) Documents cités:
- EP-A- 0 077 500
- IBM TECHNICAL DISCLOSURE BULLETIN, vol. 19, no. 9, février 1977, pages 3584-3585, New York, US; T.A. SCHWARZ: "Offset compensation circuit"
- PATENT ABSTRACTS OF JAPAN, vol. 2, no. 130, 28 octobre 1978, page 7931 E 78; & JP-A-53 97 756 (HITACHI SEISAKUSHO K.K.) 26-08-1978
- IBM TECHNICAL DISCLOSURE BULLETIN, vol. 26, no. 3B, août 1983, pages 1377-1378, New York, US; J.C. ENGELBRECHT: "Input offset compensation for photodiode amplifier"

## Description

L'invention concerne l'application d'un amplificateur différentiel à sorties différentielles, intégrable aux circuits de commutations de têtes de lecture pour magnétoscopes.

Dans certaines applications, notamment dans les circuits de commutation de têtes de lecture pour magnétoscopes qui font appel à des amplificateurs à sorties différentielles, il est indispensable pour le bon fonctionnement du circuit aval (le commutateur) qui reçoit les signaux de sortie de l'amplificateur, que ces signaux de sortie ne présentent pas de de niveau continu. D'autre part il est également indispensable qu'il n'y ait pas non plus une grande différence entre les niveaux continus ou tout au moins que cette différence de niveau continu soit la plus faible possible. Ces niveaux continus de tension sont classiquement désignés sous le terme anglo-saxon "d'offset", peuvent être d'origines multiples, et sont généralement mal déterminés. La solution usuelle pour résoudre ce problème consiste alors à placer sur l'entrée de signal de l'amplificateur une capacité de liaison, cette capacité se trouvant donc entre les circuits amont et l'amplificateur. La capacité a pour but de supprimer les causes de l'offset. Cependant toutes les causes d'offset ne sont pas supprimées. Il apparaît notamment, un niveau continu sur chacune des sorties, qui fluctue de manière indéterminée et qui est amplifié au niveau des sorties.

En effet l'amplificateur différentiel comporte classiquement deux transistors polarisés par la composante continue du signal d'entrée. Lorsqu'on utilise une capacité de liaison à l'entrée du signal, on supprime la composante continue de ce signal. Il est donc nécessaire de polariser la base des transistors. On utilise pour cela une source de référence et une résistance reliée entre cette source et la base de chacun des transistors d'amplificateur. Or, les valeurs des résistances présentent toujours une dispersion car il est impossible d'avoir des résistances de valeur strictement identiques. Un offset dû à ces dispersions apparaît au niveau des sorties de l'amplificateur. Cet offset se trouve à la sortie, amplifié par le gain donné par le circuit.

D'autre part pour effectuer la polarisation des transistors, il est nécessaire d'utiliser des résistances de valeur importante qui naturellement rajoutent du bruit. Pour éviter d'apporter du bruit avec des résistances de forte valeur on utilise des résistances de plus faible valeur et des capacités de plus forte valeur. On se heurte alors au problème de l'intégration de telles capacités. Il faut en conséquence trouver un compromis entre le bruit et l'intégration. On utilise généralement une capacité de valeur élevée mais non intégrée qui est connectée au boîtier du circuit intégré par deux broches de connexion du boîtier.

Le problème général à résoudre consiste donc à réaliser un amplificateur différentiel qui ne présente pas de variation de niveau continu entre ses sorties, qui soit intégrable, qui ne rajoute pas de bruit et qui permette l'économie de deux broches de connexion du boîtier.

Un amplificateur de ce type est décrit dans le brevet US-A-4577336.

La présente invention a donc pour objet l'application d'un amplificateur différentiel, qui comporte un circuit permettant de compenser les variations de niveau continus de l'entrée de signal et d'asservir la différence des niveaux continus des sorties sur un niveau constant sans pour autant rajouter du bruit, à un circuit de commutation de têtes de lecture pour magnétoscope.

L'invention comporte les caractéristiques énoncées en revendication 1.

L'invention sera mieux comprise à l'aide de la description détaillée et des figures annexées parmi lesquelles:
- la figure 1, représente le schéma général d'un amplificateur,
- la figure 2, représente le schéma détaillé de l'amplificateur selon la figure 1,
- la figure 3, représente le schéma de principe d'une application particulière de l'amplificateur selon l'invention.

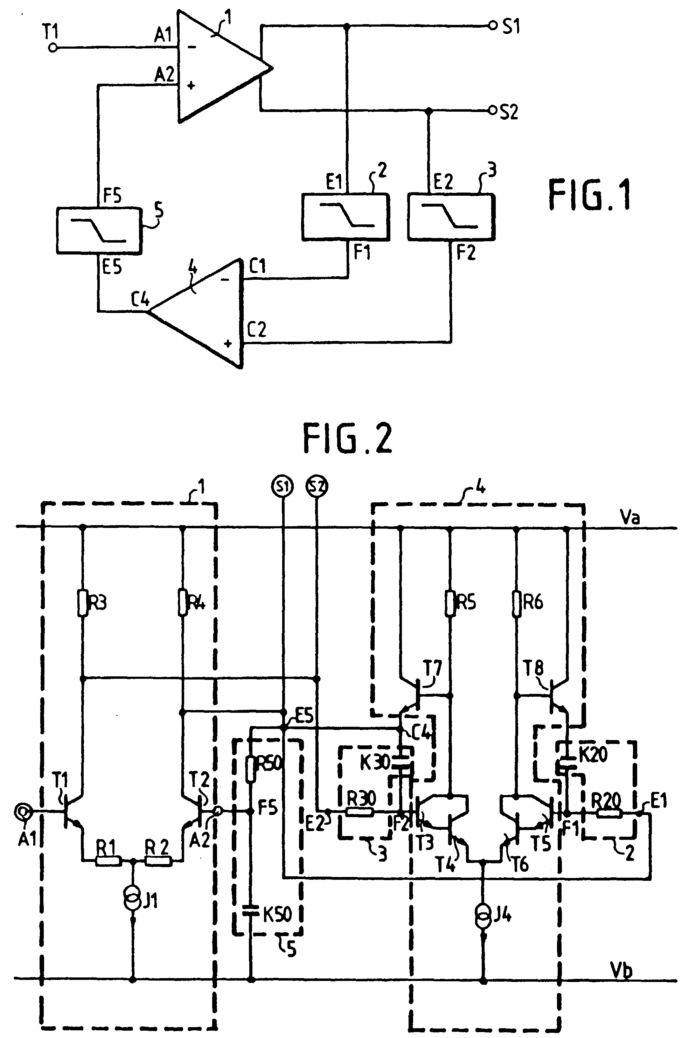

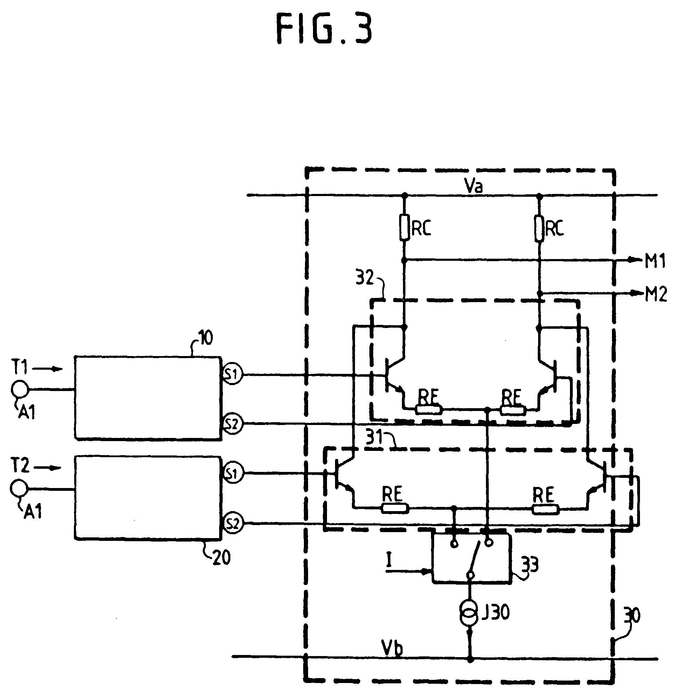

Sur la figure 1, on a donc représenté le schéma de principe d'un amplificateur différentiel. L'amplificateur 1 reçoit sur l'une de ses entrées différentielles A1, un signal T1 ayant un niveau continu mal déterminé. Ce signal T1 provient d'un circuit amont non représenté sur cette figure et qui n'est pas indispensable à la compréhension de l'invention mais dont un exemple particulier est donné dans la description de l'application illustrée par la figure 3. L'amplificateur 1 possède deux sorties différentielles S1 et S2. La sortie S1 est reliée à une entrée E1 d'un filtre passe-bas 2 et la sortie S2 est reliée à une entrée E2 d'un filtre passe-bas 3. La sortie F1 du filtre 2 est reliée à une entrée C1 d'un comparateur 4 et la sortie F2 du filtre 3 est reliée à l'autre entrée C2 du même comparateur 4. La sortie C4 du comparateur 4 est reliée soit directement à l'entrée différentielle A2 de l'amplificateur qui est destiné à recevoir une tension de référence soit indirectement par l'intermédiaire d'un filtre passe-bas 5. Ce filtre S reçoit alors à une entrée E5 le signal de sortie du comparateur 4 et sa sortie F5 est reliée à l'entrée A2 et est destiné à supprimer le bruit propre du comparateur C4 et à améliorer les performances des deux filtres Intégrables 2 et 3.

Ainsi le signal T1 qui est susceptible de comporter une composante continue, n'est pas filtré par une capacité de liaison comme dans l'art antérieur mals est directement appliqué à l'entrée de signal de l'amplificateur 1 qui amplifie le signal avec la composante continue. Ce niveau continu n'est pas le même sur chacune des sorties car il est modifié indépendamment sur l'une et l'autre des sorties par le passage du signal dans l'amplificateur à travers les résistances qui ne peuvent pas être strictement identiques. Ces niveaux continus, qui peuvent donc être différents pour les raisons précédemment indiquées, à savoir qu'il n'est pas possible d'obtenir des valeurs de résistances absolument identiques à l'intérieur du comparateur, sont filtrés par les filtres 2 et 3 de manière à obtenir à la sortie du filtre 2 la composante continue de la sortie S1 et à la sortie du filtre 3 la composante continue de la sortie S2.

L'amplificateur comporte donc une boucle de régulation qui permet de compenser les variations de la composante continue du signal d'entrée T1 et d'asservir la différence des signaux continus des sorties à une valeur tendant vers zéro. La boucle de régulation est telle que le système tend à annuler la différence de niveau continu entre les sorties différentielles S1 et S2.

Le principe de réduction de l'offset en sortie consiste donc à mesurer cet offset et à l'asservir sur une valeur tendant vers zéro.

L'amplificateur décrit ci-dessus permet donc de résoudre les problèmes énoncés précédemment à savoir la suppression de la différence de niveau continu sur les sorties différentielles, l'obtention d'un très faible niveau de bruit, une parfaite compatibilité d'intégration et de plus une réduction du nombre de broches utilisées dans le boîtier du circuit intégré comportant l'amplificateur.

Sur la figure 2, on a représenté un exemple de schéma plus détaillé de l'amplificateur de la figure 1. Les transistors T1 et T2 ont leurs émetteurs reliés respectivement par l'intermédiaire d'une résistance R1, R2 à une source de courant J1 qui est elle même reliée à une borne Vb d'alimentation. Les collecteurs des transistors T1 et T2 sont reliés par l'intermédiaire d'une résistance respectivement R3 et R4 à l'autre borne Va d'alimentation. La sortie S1 est par exemple, la sortie prise entre le collecteur du transistor T2 et une borne de la résistance R4, tandis que la sortie S2 est par exemple la sortie prise entre le collecteur du transistor T1 et une borne de la résistance R3.

Le filtre 2 est constitué par la résistance R20 et par la capacité K20 Le filtre 3 est constitué par la résistance R30 et par la capacité K30. Le signal issu de la sortie S2 est appliqué à l'entrée E2 du filtre 3. Le signal issu de la sortie F1 du filtre 2 est appliqué sur la base d'un transistor T5 du comparateur 4 et le signal issu de la sortie du filtre 3 est appliqué sur la base d'un transistor T3 de ce comparateur 4

Le comparateur est en fait constitué d'une manière classique en soi, par un circuit Darlington comportant les transistors T3, T4 et T5, T6. Les émetteurs des transistors T4, T6 sont reliés à une source de courant J4 qui elle-même est reliée au potentiel Vb de la tension d'alimentation.

Une des sorties du montage Darlington est prise au point commun reliant les collecteurs des transistors T5 et T6 et le signal collecteur de ces transistors est appliqué à la base d'un transistor T8 dont l'émetteur est relié à une borne du condensateur K20 du filtre 2 et dont le collecteur est relié au potentiel Va de la tension d'alimentation. Le transistor T8 est polarisé par une résistance R6 connectée entre sa base et le potentiel Va.

L'autre sortie du montage Darlington est constituée par le point commun des collecteurs T3, T4 qui fournit un signal qui est appliqué sur la base d'un transistor T7 polarisé par une résistance R5 connectée entre cette base et le potentiel Va de la tension d'alimentation et dont l'émetteur constitue la sortie du comparateur. Le signal pris à cette sortie C4 est appliqué à l'entrée A2 de l'amplificateur ou de manière préférentielle comme cela est représenté, à l'entrée E5 du filtre 5, la sortie F5 de ce filtre étant reliée à l'entrée A2 de l'amplificateur.

Le filtre 5 comprend la résistance R50 et le condensateur K50, la résistance étant reliée entre les bornes E5 et F5, le condensateur K50 étant relié entre la borne F5 qui est directement reliée à l'entrée de référence A2 et le potentiel Vb de la tension d'alimentation.

A titre d'exemple, si l'on désire obtenir une fréquence de coupure basse de 10kHz, on utilise des capacités K20 et K30 de 20 pF et des résistances R20, R30 de 1MΩ et une capacité K50 de 220 nF et une résistance de 1kΩ. Le condensateur K50 est extérieur au circuit intégré mais ne nécessite qu'une seule borne de connexion, c'est-à-dire la borne correspondant au point F5, car l'autre borne de connexion est dé3à existante dans le circuit puisqu'il s'agit du potentiel Vb. Ce condensateur permet en particulier de mettre à la masse des bruits issus du système comparateur. Si l'on considère que le courant de base du circuit Darlington est de l'ordre de 0,1mA et que la dispersion sur la valeur des résistances R20 et R30 est de 5%, on obtient une tension d'offset en sortie de l'ordre de 5% multipliée par la valeur de la résistance R20 ou R30 et multiplié par le courant de base, soit une tension d'offset égale à 5mV.

Sur la figure 3 on a représenté une application selon l'invention de l'amplificateur décrit ci-dessus. Cette application consiste en fait à utiliser deux amplificateur tels que décrits en référence à la figure 1 ou 2, ces amplificateurs étant utilisés comme amplificateurs du signal provenant de têtes de lecture dans un magnétoscope. Les deux têtes de lecture qui ne sont pas représentées sur cette figure fournissent les signaux T1 et T2 qu'il est nécessaire de commuter. Les deux têtes sont diamétralement opposées et viennent lire à tour de rôle l'information sur la bande du magnétoscope. On commute au rythme de la rotation de la tête la lecture d'une tête sur l'autre.

Les sorties de chacun des deux amplificateurs 10 et 20 sont reliées aux entrées d'un commutateur 30 qui permet de délivrer à ses sorties M1, M2 soit les signaux issus des sorties S1, S2 de l'amplificateur 10, soit les signaux issus des sorties S1, S2 de l'amplificateur 20. Pour que la commutation effectuée par ce commutateur 30, qui est classique en soi, soit faisable il est nécessaire qu'il n'y ait pas de grande variation entre les sorties S1, S2 de chacun des amplificateurs. Les amplificateurs permettent donc d'effectuer cette commutation entre les signaux T1 et T2. Le commutateur 30 comporte en fait deux amplificateurs différentiels 31 et 32 classiques en soi et un commutateur 33 commandé par un signal I obtenu aisément à partir des signaux d'horloge du circuit et une source de courant J30 qui est alternativement reliée par le signal I soit à l'amplificateur 32 soit à l'amplificateur 31 de manière à ce que ce soit alternativement soit les signaux de sortie de l'amplificateur 10 qui se retrouvent aux sorties M1 et M2 soit les signaux de sortie de l'amplificateur 20.

De plus, l'offset entre S1 et S2 de l'amplificateur 10 et l'offset entre Sl et S2 de l'amplificateur 20 peuvent être ainsi de même sens par exemple + 10mV et + 8mV. La différence d'offset présente à l'entrée du commutateur est malgré cela faible puisqu'elle est égale à 2mV.

## Revendications

1. Circuit de commutation de têtes de lecture pour magnétoscopes comportant un commutateur (30) et deux amplificateurs différentiels ; chaque amplificateur différentiel comprenant :
deux entrées différentielles dont l'une est une entrée de signal recevant directement un signal non filtré et l'autre une entrée de référence, et deux sorties différentielles,
un premier (2) et un deuxième (3) filtre passe-bas, le premier filtre étant relié à une sortie différentielle (S1), le deuxième filtre étant relié à l'autre sortie différentielle (S2), un comparateur (4) à deux entrées et une sortie, recevant respectivement à une entrée (C1) le signal de sortie de l'un des filtres (2) et à l'autre entrée (C2) le signal de sortie de l'autre filtre (3), la sortie (C4) du comparateur (4) étant reliée à l'entrée de référence (A2) de l'amplificateur pour effectuer une boucle de régulation qui compense les variations de niveau continu du signal (T1) appliqué à l'entrée de signal (A1) et qui asservit la différence des niveaux continus des sorties à un niveau tendant vers zéro ;
le premier amplificateur (10) recevant à l'entrée de signal, le signal (T1) issu d'une première tête de lecture, le deuxième amplificateur (20) recevant à l'entrée de signal, le signal (T2) issu de la deuxième tête de lecture, les sorties différentielles de chacun des amplificateurs étant reliées aux entrées du commutateur (30) qui comporte deux sorties (M1, M2) qui permettent de délivrer soit les signaux de sortie du premier amplificateur soit les signaux de sortie du deuxième amplificateur.

2. Circuit selon la revendication 1, caractérisé en ce que chaque amplificateur comprend un filtre passe-bas de type RC (5) entre la sortie du comparateur (4) et l'entrée de référence (A2).

3. Circuit selon la revendication 1 ou 2, caractérisé en ce que le premier (2) et le deuxième (3) filtre sont constitués par des réseaux passe-bas de type RC.

4. Circuit selon l'une quelconque des revendications 1 à 3, caractérisé en ce que tous les éléments constitutifs de chaque amplificateur sont intégrés sauf le condensateur (K50) du filtre (5) placé entre la sortie du comparateur (4) et l'entrée de référence (A2), ce condensateur étant connecté entre l'entrée de référence (A2) et une borne d'alimentation (Vb).

## Patentansprüche

1. Schaltung zum Schalten bzw. Umschalten von Leseköpfen für Magnetoskope bzw. Videorecorder, mit einem Schalter bzw. Umschalter (30) und zwei Differential- bzw. Differenzverstärkern, wobei jeder Differentialverstärker jeweils umfasst:
zwei Differential- bzw. Differenzeingänge, von welchen einer ein direkt ein ungefiltertes Signal zugeführt erhaltender Signaleingang und der andere ein Referenz- bzw. Bezugseingang ist, sowie zwei Differential- bzw. Differenzausgämge,
ein erstes (2) und ein zweites (3) Tiefpaßfilter, von welchen das erste Filter mit einem Differentialausgang (S1) und das zweite mit dem anderen Differentialausgang (S2) verbunden ist,
einen Komparator (4) mit zwei Eingängen und einem Ausgang, der an seinem einen Eingang (C1) das Ausgangssignal eines der Filter (2) und an seinem anderen Eingang (C2) das Ausgangssignal des anderen Filters (3) zugeführt erhält, wobei der Ausgang (C4) des Komparators (4) mit dem Referenz- bzw. Bezugseingang des Verstärkers verbunden ist zur Bildung einer Regelschleife, welche die Änderungen bzw. Schwankungen des Gleichstrompegels des dem Signaleingang (Al) zugeführten Signals (T1) kompensiert und die Differenz der Gleichstrompegel der Ausgänge auf einen gegen Null tendierenden Pegelwert servoregelt,
wobei der erste Verstärker (10) am Signaleingang das von einem ersten Lesekopf kommende Signal (T1) und der zweite Verstärker (20) am Signaleingang das von dem zweiten Lesekopf kommende Signal (T2) zugeführt erhalten und die Differential- bzw. Differenzausgänge jedes der Verstärker mit den Eingängen des Schalters (30) verbunden sind, der zwei Ausgänge (M1,M2) aufweist, welche die Abgabe entweder der Ausgangssignale des ersten Verstärkers oder der Ausgangssignale des zweiten Verstärkers gestatten.

2. Schaltung nach Anspruch 1, dadurch gekennzeichnet, daß jeweils jeder Verstärker ein RC - Tiefpaßfilter (5) zwischen dem Ausgang des Komparators (4) und dem Referenz-bzw. Bezugseingang (A2) aufweist.

3. Schaltung nach Anspruch 1 oder 2, dadurch gekennzeichnet, daß das erste (2) und das zweite (3) Filter durch Tiefpaßanordnungen vom RC- Typ gebildet werden.

4. Schaltung nach einem der Ansprüche 1 bis 3, dadurch gekennzeichnet, daß sämtliche jeweils jeden der Verstärker bildenden Komponenten integriert sind mit Ausnahme des Kondensators (K50) des zwischen dem Ausgang des Komparators (4) und dem Referenz- bzw. Bezugseingang (A2) liegenden Filters (5), wobei dieser Kondensator zwischen dem Referenz- bzw. Bezugseingang (A2) und einem Versorgungsanschluß (Vb) liegt.

## Claims

1. A circuit for switching the reading heads of video tape recorders comprising a switch (30) and two differential amplifiers, each differential amplifier comprising:
two differential inputs, one of which is a signal input directly receiving a non-filtered signal and the other one of which is a reference input, and two differential outputs;
a first (2) and a second (3) low-pass filter, the first filter being connected with one differential output (S1), the second filter being connected with the other differential output (S2), one comparator (4) with two inputs and one output, respectively receiving on one input (C1) the output signal from one of the filters (2) and on the other input (C2) the output signal from the other filter (3), the output (C4) of comparator (4) being connected with the reference input (A2) of the amplifier in order to form a regulation loop which compensates for the d.c. level variations of signal (T1) applied on the signal input (A1) and which servo-controls the difference of the output d.c. levels to a level approaching zero;
the first amplifier (10) receiving, at the signal input, the signal (T1) from a first reading head, the second amplifier (20) receiving at the signal input, the signal (T2) from the second reading head, the differential outputs of each of the amplifiers being connected with the inputs of said switch (30) which comprises two outputs (M1, M2) providing either the output signals from the first amplifier or the output signals from the second amplifier.

2. A circuit according to claim 1, characterized in that each amplifier comprises one low-pass filter of the RC type (5) located between the comparator output (4) and the reference input (A2).

3. A circuit according to claim 1 or 2, characterized in that the first (2) and second (3) filters are constituted by low-pass arrays of the RC type.

4. A circuit according to any of claims 1 to 3, characterized in that all the elements constituting each amplifier are integrated, except for the capacitor (K50) of the filter (5) located between the comparator output (4) and the reference input (A2), this capacitor being connected between the reference input (A2) and a supply terminal (Vb).
